# EUROPÄISCHE PATENTSCHRIFT

(11) **EP 2 080 232 B1**
(45) Veröffentlichungstag und Bekanntmachung des Hinweises auf die Patenterteilung: **18.05.2016**
(21) Anmeldenummer: 07819166.5
(22) Anmeldetag: 19.10.2007
(51) Int. Cl.: H01L 31/05

(54) **Zellverbinder zur elektrischen Kontaktierung von flächigen Stromquellen sowie dessen Verwendung dessen**
Cell connector for electrically contacting planar power sources, and use thereof
Connecteur de cellules pour la mise en contact électrique de sources de courant surfaciques, et son utilisation

(30) Priorität: 20.10.2006 DE 102006049603
(43) Veröffentlichungstag der Anmeldung: 22.07.2009
(73) Patentinhaber: Fraunhofer-Gesellschaft zur Förderung der angewandten Forschung e.V., 80686 München (DE)
(72) Erfinder: WIRTH, Harry, 79108 Freiburg (DE)
(74) Vertreter: Pfenning, Meinig & Partner mbB
(86) Internationale Anmeldenummer: PCT/EP2007/009101
(87) Internationale Veröffentlichungsnummer: WO 2008/046648

(56) Entgegenhaltungen:
- DE-A1- 19 848 682
- JP-A- 2006 270 043
- US-A- 3 466 198
- US-A1- 2003 047 206
- US-A1- 2004 094 195

## Beschreibung

Vorliegende Erfindung betrifft einen Zellverbinder (ZV) zur elektrischen Kontaktierung von flächigen Stromquellen, wobei der Zellverbinder lediglich bereichsweise mit der Stromquelle elektrisch kontaktierbar ist. Eine derartige Gestaltung dieses Verbinders gewährleistet, dass möglichst wenig mechanische Spannung, beispielsweise bei Erwärmen der gesamten Vorrichtung, auftritt.

Für den Einbau in Module werden Solarzellen auf Wafer-Basis gruppenweise elektrisch verbunden. Der Zellstrom muss aus der Zellfläche an den Zellrand und von dort weiter zu einer benachbarten Zelle geführt werden. In den meisten Fällen erfolgt das Sammeln von Teilströmen aus der Zellfläche und die Übergabe an die Nachbarzelle durch metallische Zellverbinder (ZV). Für die Kontaktierung des ZV sind in der Zellfläche oder am Zellrand Abnahmepunkte vorgesehen. Siehe das Dokument US-A-2003/047206.

Der leitfähige Querschnitt der ZV muss ausreichen, um Ströme von mehreren Ampere (5-30) pro Zelle mit geringen Verlusten durchzuleiten. Auf der anderen Seite dürfen die ZV nur begrenzte mechanische Spannungen in die Kontaktstellen einleiten. Solche mechanischen Spannungen treten zwischen benachbarten Kontaktstellen auf einzelnen Zellen wie auch beidseitig eines überbrückten Zellzwischenraums auf. Die mechanischen Spannungen werden durch thermische Ausdehnungsdifferenzen bei Produktion und Betrieb der Module sowie durch Verformung der Module verursacht.

Bei Solarzellen mit beidseitigen Kontakten (BSKZ) muss zusätzlich die vorderseitige Abschattung durch die ZV minimiert werden, bei Rückseitenkontakt-Zellen (RSKZ) entfällt diese Forderung.

Bei BSKZ werden die zellseitigen Abnahmepunkte auf der Vorderseite entlang von Geraden angeordnet und zu durchgängigen Streifen (Busbars) verbunden. Auf der Rückseite ist eine flächige Metallisierung üblich. Bei RSKZ werden die Abnahmepunkte beider Polaritäten auf der Rückseite entweder am Zellrand oder in der Zellfläche angeordnet. Liegen sie am Zellrand, so hat der ZV keine Strom sammelnde Funktion.

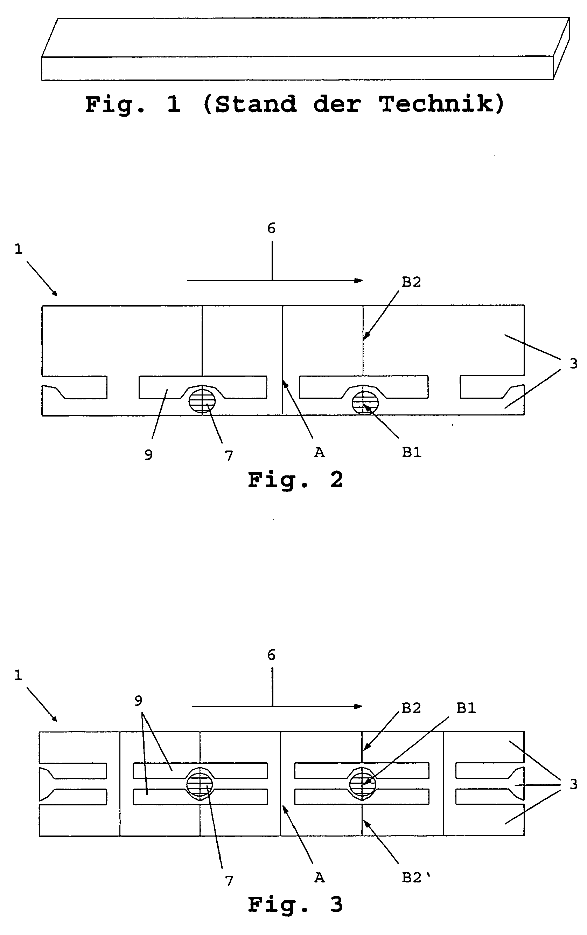

In der Modulproduktion werden flache Zellverbinder (ZV) aus beschichtetem Kupfer benutzt. Bei BSKZ ist ihr Querschnitt konstant und beträgt typischerweise ca. 2 mm x 0,15 mm (Abb. 1). Sie sind jeweils vorderseitig über die gesamte Länge auf dem Busbar einer Zelle aufgelötet und wechseln über einen Versatzabschnitt nach hinten, zur Rückseite der Nachbarzelle.

Für RSKZ mit Randkontakten werden geschlossene, gekrümmte oder rautenförmige ZV-Abschnitte zur Überbrückung des Zellzwischenraums eingesetzt, die optional miteinander verbunden sind (WO 2005 013 322, WO 2005 122 282).

In DE 43 30 282, US 6,313,395 und JP 62 016 579 wird ein Spannungs-Abbauabschnitt im ZV am Übergang zwischen den Zellen vorgeschlagen. Diese Ausführung erzeugt hohe mechanische Spannungsspitzen im ZV, ohne die Spannungen an den Abnahmepunkten der Zelle deutlich zu senken.

JP 11 312 820 beschreibt einen ZV mit einem Abbauabschnitt für mechanische Spannungen im Bereich der Zellen. Diese Abschnitte sind als Erhebungen ausgebildet. Ihre Wirksamkeit ist begrenzt, weil sie beim Laminierprozess von Verkapselungsmaterial unterspült werden und dieses Material anschließend aushärtet.

Ausgehend vom Stand der Technik ist es somit Aufgabe vorliegender Erfindung, ein Mittel zur elektrischen Verbindung von mindestens zwei Stromquellen anzugeben, das im Vergleich zum Stand der Technik eine bessere Absenkung der mechanischen Spannung an den Abnahmepunkten der Stromquellen gewährleistet, ohne jedoch negative Einflüsse auf die Stromleitfähigkeit zu haben.

Diese Aufgabe wird mit dem Zellverbinder mit den Merkmalen des Patentanspruchs 1 gelöst. Mit Patentanspruch 14 werden Verwendungszwecke des erfindungsgemäßen Mittels angegeben. Dabei stellen die jeweilig abhängigen Ansprüche vorteilhafte Weiterbildungen dar.

ES wird ein Zellverbinder in flächiger Form zur elektrischen Kontaktierung von mindestens zwei flächigen Stromquellen bereitgestellt, der aus mindestens einer erster elektrisch leitfähigen Schicht besteht, die mindestens einen Kontaktbereich zur bereichsweisen Kontaktierung mit jeder der Stromquellen aufweist, wobei der nicht kontaktierbare Bereich einen Transitbereich zur Stromleitung bildet, wobei
a) der Querschnitt (B) des Zellverbinders in dem mindestens einen Kontaktbereich in Hauptstromrichtung kleiner ist als der maximale Querschnitt (A) des Zellverbinders in Hauptstromrichtung und/oder
b) dass zumindest die erste leitfähige Schicht außerhalb des mindestens einen Kontaktbereichs mindestens einen Bereich umfasst, dessen Verlauf in Hauptstromrichtung nicht geradlinig ist und der durch mindestens eine länglich ausgeprägte Trennung oder Aussparung in mindestens zwei Streifen, die im Wesentlichen parallel zur Hauptstromrichtung laufen, unterteilt ist.

Erfindungsgemäß wird unter einem Kontaktbereich der Bereich verstanden, an dem der Zellverbinder mit der Stromquelle verbunden wird. Dies kann beispielsweise durch Löten, Verkleben oder sonstige Verbindungen erfolgen, die eine stromleitende Verbindung des Zellverbinders mit der Stromquelle ermöglichen. Unter Bezugnahme auf Figur 2 wird unter dem Querschnitt des Zellverbinders die Fläche verstanden, die beim Schnitt entlang der Linien A bzw. B1 und B2 entsteht. Dies Schnittfläche hängt somit auch von der Dicke (also der Dimensionsierung in die Zeichenebene der Figur 2) ab.

Erfindungswesentlich ist somit, dass der Zellverbinder lediglich stellenweise mit der Stromquelle verbunden ist.

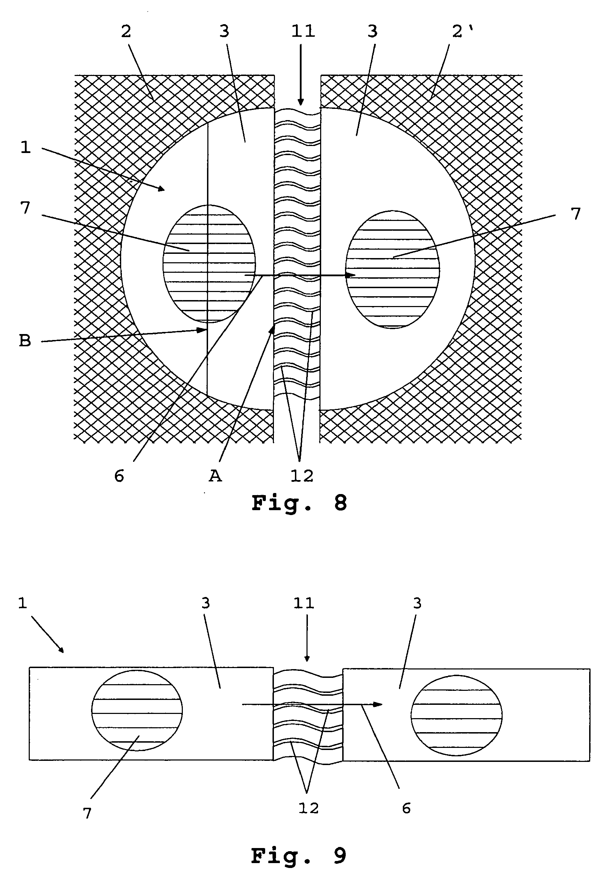

Die Verbindung zwischen zwei Kontaktstellen des ZV wird erfindungsgemäß in Bezug auf das E-Modul geschwächt
- durch Querschnitts-Verdünnung (Fig. 2,3,4,5,6,7) oder
- durch Querschnitts-Segmentierung (Fig. 8,9,10)

Eine derartige Ausgestaltung eines Mittels zur elektrischen Verbindung von Stromquellen bietet gegenüber dem Stand der Technik die folgenden Vorteile:
- Stromquellen, beispielsweise Solarzellen, ZV und Kontaktstellen werden weniger durch mechanische Spannungen belastet.
- Modulhersteller können dünnere Stromquellen verarbeiten und mit höherschmelzenden, bleifreien Loten verbinden, damit Kosten sparen und die Umwelt schützen bzw. entsprechende Auflagen erfüllen.
- Bei Ausführung des ZV mit variablem Querschnitt kann auch leitfähiges Material eingespart werden.

Vorteilhafterweise ist dabei der maximale Querschnitt (A) so dimensioniert, dass der bei elektrischer Maximallast zwischen den Stromquellen fließende Gesamtstrom ohne eine den Zellverbinder schädigende Wärmebelastung fließen kann. Somit hängt der Querschnitt direkt von der Art bzw. der Dimensionierung der verwendeten Stromquellen ab. Im Falle, dass die Stromquelle eine Solarzelle ist, hängt somit die Dimensionierung des Querschnitts beispielsweise von der Nutzfläche bzw. der Leistung der Solarzelle ab. Für kleine Solarzellen reicht hier bereits ein geringer Querschnitt aus, während bei leistungsstärkeren Solarzellen ein entsprechend größerer Querschnitt gewählt werden muss.

Weiter ist es vorteilhaft, wenn der Querschnitt des mindestens einen Bereichs so dimensioniert ist, dass der bei elektrischer Maximallast zwischen den Stromquellen fließende Gesamtstrom ohne eine den Zellverbinder schädigende Wärmebelastung fließen kann.

In einer ersten bevorzugten Ausführungsform weist dabei zumindest die erste Schicht mindestens eine Aussparung zur Texturierung auf, die an den jeweiligen Kontaktbereich angrenzt. Dies führt zu einer weiteren Erhöhung der Flexibilität des Zellverbinders. Die Texturierung kann dabei über die üblichen, aus dem Stand der Technik bekannten Verfahren erfolgen, beispielsweise Ätzen, Stanzen oder Fräsen. Der Zellverbinder behält somit eine hohe Flexibilität gegenüber der Stromquelle, so dass z.B. bei mechanischer Ausdehnung (insbesondere wenn die Stromquelle und das Material des Zellverbinders unterschiedliche Wärmeausdehnungskoeffizienten aufweisen) eine Verminderung der ansonsten auftretenden mechanischen Spannung gewährleistet ist. Die Aussparungen sind dabei auf keine besondere geometrische Form beschränkt, vorzugsweise sind sie jedoch im Wesentlichen quadratisch, rechteckig, rautenförmig, oval und/oder kreisförmig ausgebildet. Dabei weist die Gesamtfläche der mindestens einen Aussparung bezüglich der Gesamtfläche der ersten Schicht bevorzugt ein Verhältnis von 0,1 bis 0,75, bevorzugt 0,1 bis 0,5, besonders bevorzugt zwischen 0,2 und 0,4 auf.

Weiter ist es bevorzugt, wenn die Anzahl der Aussparungen der Anzahl der Kontaktbereiche 7 entspricht, d.h. dass jedem Kontaktbereich 7 eine Aussparung 9 zugeordnet ist, wobei der Kontaktbereich und die jeweilige Aussparungen in unmittelbarer Nachbarschaft zueinander stehen. Eine derartige Ausführungsform ist beispielsweise in Figur 2 gezeigt, wo auf jeweils einer Seite eines jeden Kontaktbereiches eine Aussparung angeordnet ist.

Alternativ hierzu ist es ebenso günstig, wenn jedem Kontaktbereich mindestens zwei Aussparungen zugeordnet sind, insbesondere zwei Aussparungen, die jeweils auf einer gegenüber liegenden Seite des Kontaktbereiches angeordnet sind. Eine derartige Ausführungsform ist in Figur 3 wiedergegeben, wo jeder Kontaktbereich auf beiden gegenüber liegenden Seiten von jeweils einer Aussparung 9 flankiert bzw. umgeben wird.

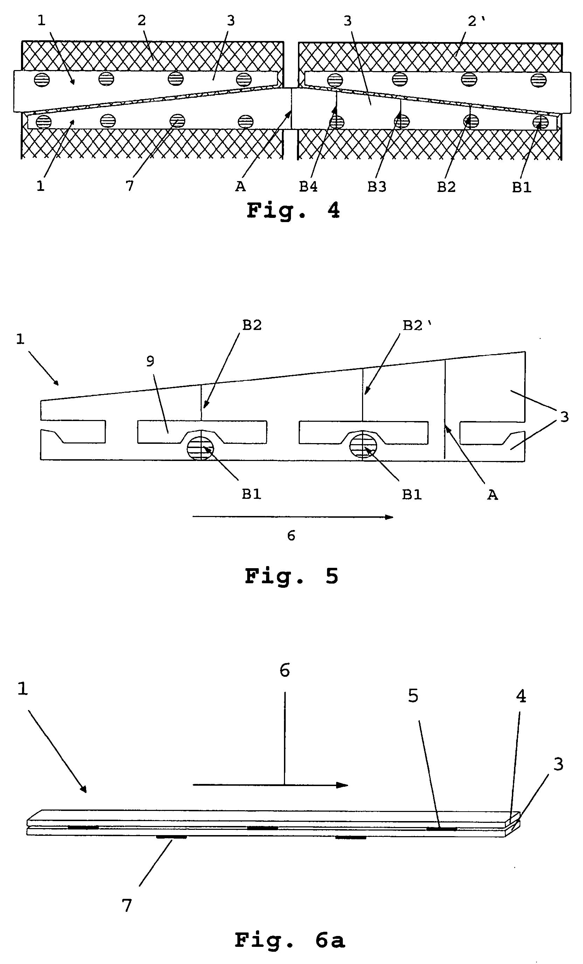

Eine weitere bevorzugte Alternative oder zusätzliche Ausführungsform sieht vor, dass der Zellverbinder einen zu- und/oder abnehmenden Querschnitt in Stromrichtung aufweist. Derartige Ausgestaltungsformen sind beispielsweise in den Figuren 4 und 5 wiedergegeben. Bei der Ausführungsform, wie sie in Figur 4 dargestellt ist, wächst der Querschnitt des Zellverbinders im Bereich der Kontaktbereiche 7 vom Randbereich ausgehend hin zur Mitte stetig an (B1 bis B4) und erreicht in der Mitte, zwischen den zu verbindenden Stromquellen, sein Maximum (Querschnitt A). Selbstverständlich kann diese vorteilhafte Ausführungsform, wonach der Querschnitt variierend ist, auch mit den im Voranstehenden diskutierten Ausführungsformen, nachdem zumindest die erste Fläche des Zellverbinders 3 eine Texturierung aufweist, kombiniert werden. Eine derartige Ausgestaltungsform ist beispielsweise in Figur 5 dargestellt.

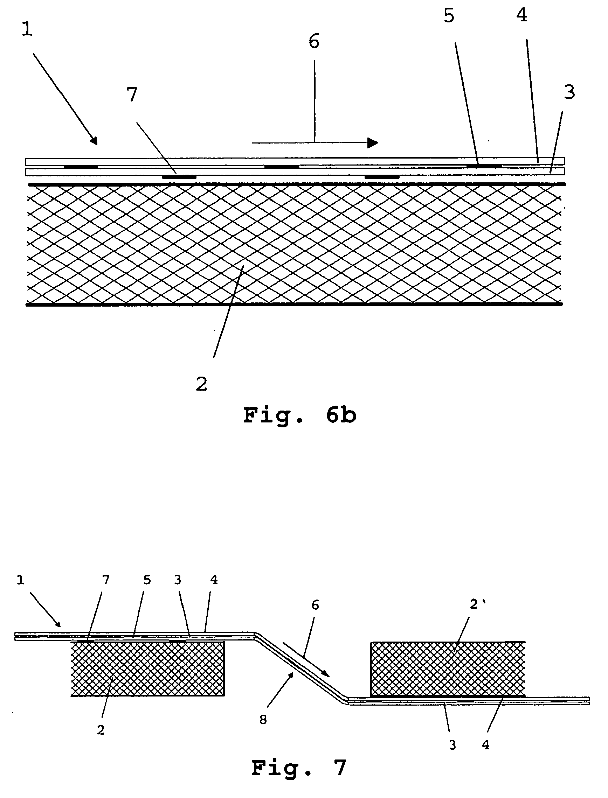

Als weitere bevorzugte Ausführungsform des Zellverbinders kann dieser derartig gestaltet sein, dass auf der zur Stromquelle abgewandten Seite der ersten Schicht eine zweite Strom leitende Schicht angeordnet ist, die mindestens einen Kontakt zur bereichsweisen Kontaktierung mit der ersten Schicht aufweist. Somit kann eine weitere Steigerung des Stromdurchsatzes und der mechanischen Festigkeit bei Vermeiden von mechanischen Spannungen erfolgen. Die Kontaktierung der beiden Schichten kann dabei über Lötkontakte erfolgen. Ebenso können in analoger Weise weitere Schichten auf der zweiten Schicht und/oder auf jeder weiteren Schicht aufgebracht sein. Dabei ist es günstig, wenn die Kontaktbereiche der ersten Schicht zur Stromquelle und die Kontaktbereiche zwischen erster und zweiter Schicht - wie in Fig. 6a, 6b und 7 dargestellt - zueinander versetzt sind.

Auch diese Ausführungsform erfüllt das Merkmal a) des geltenden Anspruchs 1. Der maximal leitende Querschnitt (A) ist hier so definiert, dass er die Summe der Schichtdicken der ersten Schicht 3, der zweiten Schicht 4 inkls. des zwischen den Schichten angeordneten Kontaktes 5 repräsentiert. Im Bereich der Kontaktierung der ersten Schicht mit der Stromquelle, in der keine Kontaktierung zwischen den beiden Schichten 3 und 4 vorhanden ist, weist der gesamte Zellverbinder 1 somit einen geringeren Querschnitt auf, da hier ja zwischen den Schichten 3 und 4 kein Kontakt 5 angebracht ist. Selbstverständlich können sowohl die Schicht 3 als auch die Schicht 4 sowie jede weitere Schicht die in den Figuren 2 und 3 dargestellten Texturierungen aufweisen, wobei diese Strukturierungen dann derartig ausgestaltet sind, dass beispielsweise die Schicht 3 in Richtung der Schicht 4 durchbrochen ist; andererseits ist hier auch vorstellbar, dass die Schichten 3 und/oder 4 einen entsprechenden variierenden Querschnitt (wie in Figur 4 dargestellt) aufweisen. Selbstverständlich sind auch Kombinationen der zuvor genannten Möglichkeiten gegeben, wie dies in Figur 5 dargestellt ist.

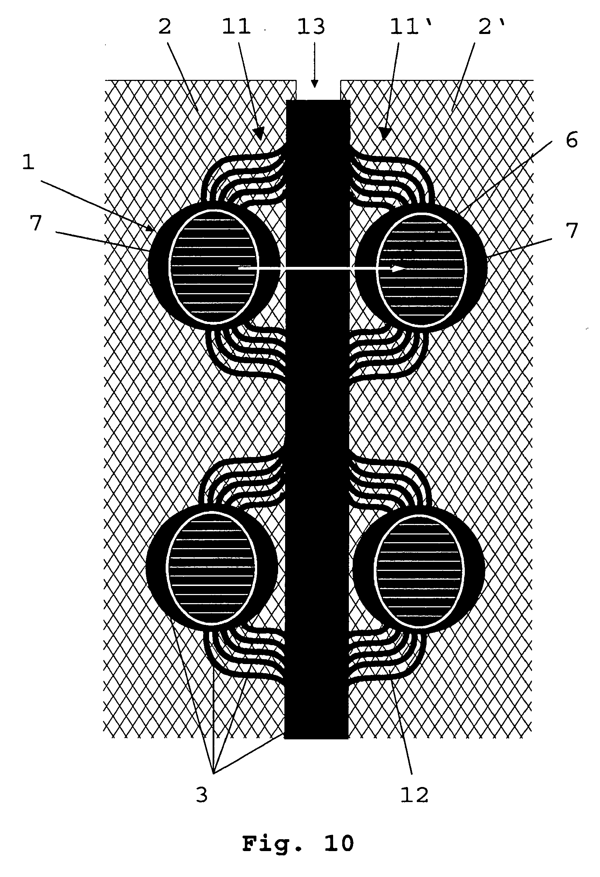

Als weitere bevorzugte Ausführungsform ist vorgesehen, dass die länglichen Aussparungen 12 kanalförmig, bogenförmig, wellenförmig, zumindest annähernd sinusförmig, S-förmig, und/oder lamellar ausgebildet sind. Dadurch wird zumindest die erste leitfähige Schicht des ZV im mehrere, quasi parallel in Hauptstromrichtung verlaufende Bereiche oder Streifen aufgeteilt, die durch die Aussparungen senkrecht zur Hauptstromrichtung physikalisch voneinander getrennt sind. Unter Bezugnahme auf die Figuren 8 bis 10 können diese Aussparungen derart ausgestaltet sein, dass sie z.B. zwischen den Solarzellen angeordnet sind, wobei hier diese Aussparungen im Wesentlichen parallel zueinander verlaufen und geschwungen ausgebildet sein können. Alternativ hierzu sind auch bogenförmige Ausgestaltungen, entsprechend der Darstellungsweise der Figur 10 denkbar. Als gemeinsames Merkmal weisen diese Strukturen jedoch eine lose Anordnung von mehreren leitfähigen Bändern auf, über die eine effiziente mechanische Spannungsminderung erfolgen kann. Wichtig hierbei ist, dass diese losen Elemente untereinander keine Verbindung aufweisen. Weiterhin ist es dabei günstig, wenn der Querschnitt des ZV gemäß Fig. 8 im Bereich des Kontaktes 7 einen geringeren Querschnitt B als der maximale Querschnitt A aufweist.

Insbesondere ist hierbei vorteilhaft, wenn der mindestens eine Bereich mindestens zwei, bevorzugt 2 bis 50, weiter bevorzugt 3 bis 25, besonders bevorzugt 4 bis 15 länglich ausgeprägte Aussparungen zur Texturierung aufweist.

Für die optionalen weiteren Schichten kann diese vorteilhafte Ausgestaltungsform selbstverständlich ebenso zutreffen. Darunter ist zu verstehen, dass zum mechanischen Spannungsabbau texturierte Strukturen (beispielsweise Kanäle, Ausnehmungen oder Aussparungen, die kanalförmig, linienförmig und/oder lamellar ausgebildet sein können) in den Bereich zwischen zwei Stromquellen in die jeweilige Schicht eingebracht sind. Somit wird die mechanische Flexibilität der Transitschicht zwischen zwei Stromquellen deutlich erhöht. Bevorzugt beträgt die Breite der Aussparung zwischen 10 µm und 1000 µm, bevorzugt zwischen 50 µm und 300 µm.

Weiterhin kann es vorteilhaft sein, wenn zumindest die erste leitfähige Schicht 3 außerhalb des mindestens einen Kontaktbereichs 7 mindestens zwei Bereiche 11 und 11' umfasst, die mindestens eine länglich ausgeprägte Aussparung 12 zur Texturierung aufweisen, deren Verlauf in Hauptstromrichtung 6 nicht geradlinig ist, wobei die Bereiche 11 und 11' über einen Bereich 13 verbunden sind, der ohne Aussparung ausgebildet ist. Eine derartige Ausführungsform ist in Fig. 10 dargestellt.

Hierbei weist der Bereich 13 einen größeren Querschnitt in Hauptstromrichtung 6 auf, als es der Summe der Querschnitte des Bereichs 11 sowie der Kontaktbereiche 7 entspricht. Diese besonders bevorzugte Ausführungsform entspricht somit der Kombination der Merkmale a) und b) des Hauptanspruchs. Durch den Bereich 13 wird gewährleistet, dass möglichst große Ströme zwischen den beiden Stromquellen fließen können.

Weiterhin ist es insbesondere bei langgestreckten ZV-Abschnitten (z.B. ab 5 mm) von Vorteil, wenn der Kontaktbereich so ausgebildet ist, dass das Verhältnis der Kontaktfläche zur der Gesamtfläche der leitfähigen ersten Schicht kleiner als 0,2, bevorzugt kleiner 0,1 beträgt. Unter der Kontaktfläche wird dabei die Fläche verstanden, die der Kontaktbereich im Querschnitt aufweist. Unter Bezugnahme auf die Figuren ist dies die Fläche, die die Projektion des Kontaktbereichs 7 auf die Schicht 3 ausmacht. Diese Definition gilt auch für die Zwischenkontakte 5. Unter der Gesamtfläche der ersten Schicht wird die gesamte Oberfläche einer Seite der Schicht 3 verstanden, an die der jeweilige Kontakt 5 bzw. 7 aufgebracht ist.

In einer alternativen Ausführungsform ist es jedoch ebenso möglich, dass der Kontaktbereich so ausgebildet ist, dass das Verhältnis der Kontaktfläche zur Gesamtfläche der leitfähigen ersten Schicht zwischen 0,1 und 0,85, bevorzugt zwischen 0,3 und 0,7, besonders bevorzugt zwischen 0,4 und 0,6 beträgt.

Dabei ist es günstig, wenn pro Stromquelle mindestens 2, bevorzugt 3 bis 10 Kontaktbereiche vorhanden sind. Diese Kontaktbereiche sind dann insbesondere so gestaltet, dass ihre jeweilige Kontaktfläche bezüglich der Gesamtfläche der leitfähigen ersten Schicht insbesondere bei langgestreckten ZV-Abschnitten klein ist. Durch das Vorhandensein mehrerer Kontakte ergibt sich ein synergetischer Effekt aus mechanischer Stabilität und Flexibilität, was einen deutlichen Spannungsabbau ermöglicht. Dabei ist es weiterhin bevorzugt, wenn die Kontaktbereiche regelmäßig zueinander beabstandet sind. Darunter sind regelmäßige ein- und zweidimensionale Muster und/oder Anordnungen zu verstehen, beispielsweise in linearer, quadratischer, hexagonaler und/oder rautenförmiger Anordnung. Eine alternative Ausführungsform sieht vor, dass der Zellverbinder so gestaltet ist, dass pro Stromquelle lediglich ein Kontaktbereich vorhanden ist. Dieser Kontaktbereich weist dann bevorzugt eine größere Kontaktfläche bezüglich der Gesamtfläche der ersten leitfähigen Schicht auf.

Ebenso ist es jedoch möglich, dass die Stromquellen lediglich Abnahmestellen am Rand aufweisen. In diesem Fall überbrückt der ZV vor allem den Zwischenraum benachbarter Stromquellen, wobei dieser Zwischenraum 11 durch lamellare Strukturierung flexibilisiert wird (Fig. 8). Dadurch ergeben sich die gleichen Vorteile wie bei den voranstehend genannten Ausführungsformen.

Weiterhin ist es bevorzugt, wenn der mindestens eine pro Stromquelle vorhandene Kontaktbereich im Randbereich des Zellverbinders angeordnet ist. Hierunter wird verstanden, dass die Kontaktbereiche im Wesentlichen an den am weitesten außen liegenden Punkten des ZV angeordnet sind.

Alternativ ist es aber genauso möglich, dass der mindestens eine pro Stromquelle vorhandene Kontaktbereich quer zur Stromrichtung im Wesentlichen mittig im Zellverbinder angeordnet ist.

Ebenso ist es möglich, dass zwischen der ersten Schicht und den Stromquellen und/oder zwischen der ersten und zweiten Schicht und/oder zwischen den jeweils weiteren Schichten eine isolierende Schicht angeordnet ist, wobei die isolierende Schicht jeweils durch die Kontaktbereiche durchbrochen ist.

Bezüglich seiner Abmessungen ist der Zellverbinder so gestaltet, dass er bandartige Struktur besitzt, d.h. eine Dicke im Bereich von einigen µm bis einige 100 µm aufweist und eine Breite im Bereich von einigen mm. Dabei sind die Abmessungen auf keine besonderen Maße beschränkt, vorzugsweise liegt jedoch die Schichtdicke der mindestens einen ersten und/oder jeder weiteren Schicht unabhängig voneinander zwischen 10 µm und 300 µm, bevorzugt zwischen 20 µm und 100 µm.

Die Breite der mindestens einen ersten und/oder jeder weiteren Schicht unabhängig voneinander liegt zwischen 0,5 mm und 50 mm, bevorzugt zwischen 1 mm und 10 mm.

Bezüglich der Materialien, aus denen der Zellverbinder gebildet ist, unterliegt das Mittel erfindungsgemäß keiner Beschränkung, lediglich, dass das Material ausgewählt sein muss aus leitfähigen Materialien mit einem geringen Widerstand. Vorzugsweise sind die Bestandteile des Zellverbinders jedoch ausgewählt aus der Gruppe bestehend aus Kupfer, Aluminium und/oder Silber.

Die flächige Stromquelle ist dabei bevorzugt eine Solarzelle und/oder Brennstoffzelle.

Dabei ist es unerheblich, wie der Zellverbinder zur Verbindung der flächigen Stromquellen angewendet wird. Beispielsweise kann das Mittel als Front-, Rückseiten- und/oder Seitenkontakt auf der Stromquelle aufgebracht sein. Die Stromquellen können durch das Mittel parallel und/oder seriell miteinander verschaltet werden. Dabei kann das Mittel auch einen Front- mit einem Rückseitenkontakt, beispielsweise einer Solarzelle verbinden, so dass es eine stufenförmigen Struktur besitzt.

Vorliegende Erfindung wird anhand der beigefügten Figuren näher erläutert, ohne die Erfindung auf die dort dargestellten speziellen Ausführungsformen beschränken zu wollen.

Dabei zeigen
- Figur 1: einen Zellverbinder zur Verbindung von Solarzellen, wie er aus dem Stand der Technik bekannt ist,
- Figur 2: ein einschichtiger, texturierter Zellverbinder zur Verbindung von Solarzellen,
- Figur 3: ein einschichtiger, texturierter Zellverbinder zur Verbindung von Solarzellen, wobei durch die Texturierung zwei Transitbereiche jeweils neben den Kontaktbereichen angeordnet sind,
- Figur 4: eine Anordnung von Solarzellen, die über einen Zellverbinder verbunden sind, der einen variierenden Querschnitt in Stromrichtung besitzt,
- Figur 5: einen texturierten Zellverbinder zur Verbindung von Solarzellen, der einen variierenden Querschnitt in Stromrichtung aufweist,
- Figur 6: einen erfindungsgemäßen Zellverbinder zur Verbindung von Solarzellen, der einen zweischichtigen Aufbau aufweist, (auf einer Solarzelle aufgebracht Figur 6A sowie perspektivisch dargestellte Figur 6B),
- Figur 7: eine Verbindungsmöglichkeit von zwei Solarzellen über einen erfindungsgemäßen Zellverbinder, der einen Absatz aufweist,
- Figur 8: einen flächig ausgebildeten Zellverbinder zur Verbindung von Solarzellen mit Abnahmestellen im Randbereich, wobei der Zellverbinder im Bereich zwischen den Solarzellen texturiert ist,
- Figur 9: ein Mittel analog Figur 8 in rechteckiger Ausführungsform, wobei der Zellverbinder im Bereich zwischen den Solarzellen oder über den Zellen texturiert ist.
- Figur 10: einen flächig ausgebildeten Zellverbinder zur Verbindung von Solarzellen mit Abnahmestellen im Randbereich, wobei die Kontaktbereiche paarweise über einen texturierten Bereich an einem Verbindungsstück befestigt ist, dass mehrere Kontaktpaare trägt. Der Strom fließt senkrecht zum Verbindungsstück.

Fig. 1 zeigt einen Zellverbinder, wie er aus dem Stand der Technik bekannt ist. Der Zellverbinder ist dabei als durchgehendes Kupferband ausgestaltet und im Bereich des Kontaktes mit der Stromquelle durchgehend mit dieser verbunden. Somit ergibt sich keine Möglichkeit, auftretende mechanische Spannungen abzubauen.

In Fig. 2 ist ein ZV1 dargestellt, der einen texturierten einschichtigen Aufbau besitzt. Dabei stellen die texturierten Bereiche 9 Aussparungen dar, die hier quasi rechteckförmig ausgebildet sind. Bei Rückseitenkontakt-Zellen wirft der ZV 1 keinen Schatten, so dass die Schicht 3 zur Erhöhung der Leitfähigkeit breit ausgeführt sein kann. Die Schicht 3 verbessert die Durchleitung des gesammelten Stroms und kann eine zusätzliche isolierende Schicht zur Zelle hin aufweisen. Die Stromsammlung und -führung erfolgt von der Solarzelle 2 über die Kontaktbereiche 7 und die Schicht 3. Lediglich die Kontaktpunkte 7 sind mit der Stromquelle 2 verbunden. Diese Kontaktierung 7 kann beispielsweise über Lötkontakte erfolgen. Selbstverständlich kann hier auch noch eine weitere leitende Schicht auf der ersten Schicht 3 (in Bildebene oberhalb) durch Lötkontakte 5 aufgebracht sein. Erfindungswesentlich hierbei ist, dass der Querschnitt des Zellverbinders 1, der sich durch Schnitt entlang der in Figur 2 dargestellten Linie A ergibt, größer ist als der Querschnitt, der durch Schnitt des Zellverbinders entlang der Linien B1 und B2 entsteht. Somit ist die Querschnittsfläche im Kontaktbereich kleiner als die maximale Querschnittsfläche des Zellverbinders 1. Dadurch wird eine exzellente Flexibilisierung erreicht.

Wie in Fig. 3 dargestellt, kann die Texturierung 9 auch so erfolgen, dass ein einschichtiger Aufbau resultiert, bei dem die Kontaktbereiche 7 auch zwischen zwei Texturierungen 9 angeordnet werden können. Dies führt zu einer verbesserten Flexibilität des ZV 1. Ansonsten gelten die gleichen Ausführungen wie zu Fig. 2. Die Figuren stellen Aufsichten auf den jeweiligen ZV 1 dar. Wie schon in Figur 2 erwähnt, ist auch hier der Querschnitt, der sich entlang der Linien B1, B2 und B2' in Figur 3 ergibt, also die Querschnittsfläche des Kontaktbereiches 7, kleiner als der maximale Querschnitt des Zellverbinders 1. Dadurch dass die Aussparungen jeweils paarseitig am Kontaktbereich 7 angebracht sind, ist eine weitere Erhöhung der Flexibilität des Zellverbinders 1 gegeben.

Fig. 4 zeigt eine Ausführung mit variierendem Querschnitt des ZV 1. Bei dieser Aufsicht ist somit der Kontaktbereich 7 nicht direkt einsehbar und durch den schraffierten Bereich gekennzeichnet. Durch die lediglich punktuelle Kontaktierung ergibt sich eine hohe mechanische Flexibilität, während der zunehmende Querschnitt des ZV 1 hin zum Bereich zwischen den Stromquellen 2 und 2' gewährleistet, dass eine verbesserte Stromleitung des über die Gesamtheit der Kontakte 7 akkumulierten Stroms gegeben ist. Der in Figur 4 dargestellte Zellverbinder 1 zeichnet sich nun dadurch aus, dass vom Randbereich beginnend sein Querschnitt stetig ansteigt (dies entspricht den Querschnittsflächen, die durch Schnitt des Zellverbinders entlang der Linien B1, B2, B3 und B4 entstehen. Seinen maximalen Querschnittsbereich erreicht der ZV1 im verbrückenden Bereich zwischen zwei Solarzellen 2 und 2'. Diese Erhöhung des Querschnitts erfolgt dadurch, dass der Stromfluss in Stromrichtung, also zwischen den beiden Zellen 2 und 2', über die vier Kontakte 7 akkumuliert und somit erhöht wird. Durch den sich erhöhenden Querschnitt in Stromrichtung ist nun gewährleistet, dass eine effiziente Stromleitung gewährleistet ist.

Ein ZV 1 mit variierendem Querschnitt ist aber auch in einer in Fig. 5 dargestellten Ausführungsform möglich, bei der zusätzlich eine Texturierung 9 der Schicht 3 vorhanden ist. Es gelten die Ausführungen zu Fig. 2 und 3. Somit ist diese Ausführungsform eine Kombination des zunehmenden Querschnitts aus Fig. 6 und der Ausführung der Kontaktabschnitte nach Fig. 4. Auch bei dieser Ausführungsform ist stets gewährleistet, dass die Querschnittsfläche in den Kontaktbereichen 7 (gekennzeichnet durch die Summe der Schnittflächen entlang der Linien B1 und B2 bzw. B1 und B2') stets kleiner ist als der maximale Querschnitt, z.B. entlang der Linie A.

Fig. 6a und 6b zeigen einen ZV 1, der aus zwei Schichten 3, 4 besteht. Dabei zeigt Fig. 6a den Aufbau eines ZV 1 aus zwei Schichten, während Fig. 6b die elektrische Kontaktierung des ZV 1 mit einer Solarzelle 2 darstellt. Der Pfeil 6 markiert die Stromrichtung. Die beiden Schichten 3, 4 sind nur abschnittsweise 5 miteinander verbunden, z.B. gelötet oder leitfähig geklebt. Die Kontaktierung 7 mit der Solarzelle erfolgt ebenfalls abschnittsweise über die zellzugewandte Schicht 3 des ZV 1. Die Verbindungsstellen 5 und 7 sind dabei gegeneinander versetzt. Die Kontaktbereiche 7 sind über einen geringeren Querschnitt mit dem ZV 1 verbunden, als es seinem maximalen, elektrisch leitfähigen Querschnitt entspricht. Hierbei stellt der maximale leitfähige Querschnitt die Summe der Schichtdicken 3 und 4 sowie der Kontakte 5 dar; der geringere Querschnitt des Kontaktbereiches 7 ist hingegen nur durch die beiden Schichtdicken 3 und 4 definiert. Wird ein solcher mehrschichtiger ZV 1 mit einem Absatz 8 (Fig. 7) versehen, wie er zur seriellen Schaltung von Solarzellen benötigt wird, besteht eine verminderte Bruchgefahr bei Dehnung, weil eine geringere Vorbelastung des losen Verbundes an den Biegekanten erfolgt.

Fig. 8 zeigt eine beispielhafte Ausführung eines mehrfach geteilten, indirekten Verlaufs in lamellarer Form 12 des ZV 1, der zwei benachbarte RSKZ mit Randkontakten verbindet. Durch die Aufteilung des Verbindungsquerschnitts in lamellare Strukturen, die durch S-förmige Einschnitte in den die beiden Solarzellen 2 und 2' verbrückenden Teil 11 des ZV 1 erzeugt wurden, sinkt die Biegesteifigkeit von derart bogenförmigen Verbindungsstücken deutlich, es wird ein Übergang vom steifen zum losen Verbund realisiert. In einem ZV 1 mit einer Materialstärke von bspw. 100 µm sind Spaltbreiten unter 100 µm herstellbar. Ein solcher Verlauf kann auch in beliebig anders ausgeführten ZV 1 zum mechanischen Spannungsabbau vorgesehen werden, beispielsweise in rechteckiger Form, wie in Fig. 9 dargestellt. Auch bei der in Figur 8 dargestellten Ausführungsform zeichnet sich der ZV 1 dadurch aus, dass sein Querschnitt entlang der Linie B, die im Kontaktbereich verläuft, kleiner ist, als sein maximaler Querschnitt (gekennzeichnet durch die Linie A). Selbstverständlich sind auch hier mehrschichtige Aufbauten denkbar, wobei auch hier die Kontaktierung im Falle mehrerer Schichten lediglich punktuell zu erfolgen hat.

In Fig. 10 ist ein Zellverbinder 1 zur Verbindung von Solarzellen (2, 2') dargestellt, der Abnahmestellen 7 im Randbereich aufweist. Dabei ist die Schicht 3 paarweise über die Kontaktbereiche 7 mit den Solarzellen (2, 2') kontaktiert und verfügt über texturierte Bereiche 11 und 11', die lamellare Aussparungen 12 aufweisen und an einem Verbindungsstück 13 befestigt sind, das mehrere Kontaktpaare trägt. Der Strom fließt senkrecht 6 zum Verbindungsstück 13. Diese Ausführungsform zeichnet sich dadurch aus, dass die Bereiche 11 und 11', die das Verbindungsstück 13 beidseitig kontaktieren, durch mehrere, bogenförmige Aussparungen texturiert bzw. strukturiert sind, wodurch sich ein loser Verbund von mehreren Leitersträngen ergibt. Dabei ist kennzeichnend, dass diese Leiterstränge nicht untereinander verbunden sind, so dass diese Leiterstränge eine äußerst hohe Flexibilität gegeneinander aufweisen. Eine derartige Anordnung ermöglicht eine äußerst effiziente Minderung bzw. einen Abbau von mechanischen Spannungen.

## Patentansprüche

1. Zellverbinder (1) in flächiger Form zur elektrischen Kontaktierung von mindestens zwei flächigen Stromquellen (2, 2'), aus mindestens einer ersten elektrisch leitfähigen Schicht (3), die mindestens einen Kontaktbereich (7) zur bereichsweisen Kontaktierung mit jeder der Stromquellen (2, 2') aufweist, **dadurch gekennzeichnet,**
a) **dass** der Zellverbinder entlang der Hauptstromrichtung (6) mindestens zwei Kontaktbereiche (7) aufweist, wobei der Querschnitt (B) des Zellverbinders (1) in dem mindestens einen Kontaktbereich (7) in Hauptstromrichtung (6) kleiner ist als der maximale Querschnitt (A) des Zellverbinders (1) in Hauptstromrichtung (6), wobei der Zellverbinder (1) einen zu- und/oder abnehmenden Querschnitt in Hauptstromrichtung (6) aufweist,
und/oder
b) **dass** zumindest die erste leitfähige Schicht (3) außerhalb des mindestens einen Kontaktbereichs (7) mindestens einen Bereich (11) umfasst, dessen Verlauf in Hauptstromrichtung (6) nicht geradlinig ist und der durch mindestens zwei länglich ausgeprägte Trennungen oder Aussparungen (12) in mindestens drei Streifen, die im Wesentlichen parallel zur Hauptstromrichtung (6) laufen, unterteilt ist, wobei die Aussparungen (12) kanalförmig, bogenförmig, wellenförmig, zumindest annähernd sinusförmig, S-förmig, und/oder lamellar ausgebildet sind.

2. Zellverbinder (1) nach Anspruch 1, **dadurch gekennzeichnet, dass** zumindest die erste Schicht (3) mindestens eine Aussparung (9) zur Texturierung aufweist, die an den mindestens einen Kontaktbereich (7) angrenzt.

3. Zellverbinder (1) nach einem der beiden vorhergehenden Ansprüche, **dadurch gekennzeichnet, dass** die Anzahl der Aussparungen (9) der Anzahl der Kontaktbereiche (7) entspricht.

4. Zellverbinder (1) nach einem der Ansprüche 2 bis 3, **dadurch gekennzeichnet, dass** an jeden Kontaktbereich (7) mindestens zwei Aussparungen (9) angrenzen.

5. Zellverbinder (1) nach vorhergehendem Anspruch, **dadurch gekennzeichnet, dass** an jeden Kontaktbereich (7) zwei Aussparungen (9) angrenzen, die je auf der gegenüberliegenden Seite des Kontaktbereichs (7) angeordnet sind.

6. Zellverbinder (1) nach einem der vorhergehenden Ansprüche, **dadurch gekennzeichnet, dass** auf der zur Stromquelle abgewandten Seite der ersten Schicht (3) eine zweite Strom leitende Schicht (4) angeordnet ist, die über mindestens einen Kontakt (5) bereichsweise mit der ersten Schicht (3) kontaktiert ist.

7. Zellverbinder (1) nach vorhergehendem Anspruch, **dadurch gekennzeichnet, dass** auf die zweite Schicht (4) mindestens eine weitere Strom leitende Schicht angeordnet ist, die über mindestens einen Kontakt bereichsweise mit der jeweilig darunter liegenden Schicht kontaktiert ist.

8. Zellverbinder (1) nach einem der vorhergehenden Ansprüche, **dadurch gekennzeichnet, dass** zumindest die erste leitfähige Schicht (3) außerhalb des mindestens einen Kontaktbereichs (7) mindestens zwei Bereiche (11) und (11') umfasst, die mindestens zwei länglich ausgeprägte Aussparungen (12) zur Texturierung aufweisen, deren Verlauf in Hauptstromrichtung (6) nicht geradlinig ist, wobei die Bereiche (11) und (11') über einen Bereich (13) verbunden sind, der ohne Aussparung ausgebildet ist.

9. Zellverbinder (1) nach einem der vorhergehenden Ansprüche, **dadurch gekennzeichnet, dass** pro Stromquelle (2, 2') mindestens 2, bevorzugt 3 bis 10 Kontaktbereiche (7) vorhanden sind.

10. Zellverbinder (1) nach einem der vorhergehenden Ansprüche, **dadurch gekennzeichnet, dass** der mindestens eine pro Stromquelle (2, 2') vorhandene Kontaktbereich (7) im Wesentlichen im Randbereich des Zellverbinders (1) angeordnet ist.

11. Zellverbinder (1) nach einem der Ansprüche 1 bis 5, **dadurch gekennzeichnet, dass** der mindestens eine pro Stromquelle (2, 2') vorhandene Kontaktbereich (7) und/oder (5) quer zur Stromrichtung (6) im Wesentlichen mittig im Zellverbinder (1) angeordnet ist.

12. Zellverbinder (1) nach einem der vorhergehenden Ansprüche, **dadurch gekennzeichnet, dass** zwischen der ersten Schicht (3) und den Stromquellen (2, 2') und/oder zwischen der ersten (3) und zweiten Schicht (4) und/oder zwischen den jeweils weiteren Schichten eine isolierende Schicht angeordnet ist, wobei die isolierende Schicht jeweils durch die Kontaktbereiche (7) durchbrochen ist.

13. Zellverbinder (1) nach einem der vorhergehenden Ansprüche, **dadurch gekennzeichnet, dass** die Schichtdicke der mindestens einen ersten (3) und/oder jeder weiteren Schicht unabhängig voneinander zwischen 10 µm und 300 µm, bevorzugt zwischen 20 µm und 100 µm liegt.

14. Verwendung eines Zellverbinders (1) nach einem der vorhergehenden Ansprüche zur elektrischen Verbindung von mindestens zwei flächigen Stromquellen (2, 2'), bevorzugt Solarzellen und/oder Brennstoffzellen sind.

## Claims

1. Cell connector (1) in a flat shape for the electrical contacting of at least two flat power sources (2, 2') from at least one first electrically conductive layer (3) which has at least one contact area (7) for the area-by-area contacting with each of the power sources (2, 2'), **characterised in that**,
a) the cell connector has at least two contact areas (7) along the main direction of current flow (6), wherein the cross section (B1) of the cell connector (1) in the at least one contact area (7) in the main direction of current flow (6) is smaller than the maximum cross section (A) of the cell connector (1) in the main direction of flow (6), wherein the cell connector (1) has an increasing or decreasing cross section in the main direction of current flow (6),
and/or
b) at least the first conductive layer (3) outside the at least one contact area (7) includes at least one area (11) whose course in the main direction of current flow (6) is not linear, and which is divided by at least two elongated pronounced partitions or recesses (12) into at least three strips which run substantially in parallel to the main direction of current flow (6), wherein the recesses (12) are duct-shaped, arc-shaped, wave-shaped, at least roughly sinusoidal, S-shaped and/or have a lamellar design.

2. Cell connector (1) according to claim 1, **characterised in that** at least the first layer (3) has at least one recess (9) for texturizing, which borders on the at least one contact area (7).

3. Cell connector (1) according to one of the two preceding claims, **characterised in that** the number of recesses (9) corresponds to the number of contact areas (7).

4. Cell connector (1) according to one of claims 2 to 3 , **characterised in that** at least two recesses (9) border on each contact area (7)

5. Cell connector (1) according to the preceding claim, **characterised in that** at least two recesses (9) border on each contact area (7), said recesses each being mounted on the opposite side of the contact area (7).

6. Cell connector (1) according to one of the preceding claims, **characterised in that** a second electrically conductive layer (4) is arranged on the side of the first layer (3) facing away from the power source is, said electrically conductive layer being electrically contacted area-by-area with the first layer (3) by at least one contact (5).

7. Cell connector (1) according to the preceding claim, **characterised in that** at least one additional electrically conductive layer is arranged on the second layer (4), said electrically conductive layer being electrically contacted area-by-area with the respective layer below by at least one contact.

8. Cell connector (1) according to one of the preceding claims, **characterised in that** at least the first conductive layer (3) outside the at least one contact area (7) includes at least two areas (11) and (11') which have at least two elongated pronounced recesses (12) for texturizing, whose course in the main direction of current flow (6) is not linear, wherein the areas (11) and (11') are connected across an area (13) which is designed without a recess.

9. Cell connector (1) according to one of the preceding claims, **characterised in that** there are at least 2, ideally 3 to 10 contact areas (7) present per power source (2, 2')

10. Cell connector (1) according to one of the preceding claims, **characterised in that** the at least one existing contact area (7) per power source (2, 2') is substantially arranged in the border region of the cell connector (1).

11. Cell connector (1) according to one of claims 1 to 5, **characterised in that** the at least one existing contact area (7) and/or (5) per power source (2, 2') is arranged across the direction of current flow (6) substantially in the centre of the cell connector (1).

12. Cell connector (1) according to one of the preceding claims, **characterised in that** an insulating layer is arranged between the first layer (3) and the power sources (2, 2') and/or between the first (3) and second layer (4) and/or between the respective other layers, wherein each insulating layer is pierced by the contact areas (7).

13. Cell connector (1) according to one of the preceding claims, **characterised in that** the layer thickness of the at least one first (3) and/or each additional layer irrespective of each other is between 10µm and 300µm, ideally between 20µm and 100µm.

14. Use of a cell connector (1) according to one of the preceding claims for the electrical connection of at least two flat power sources (2, 2'), ideally solar cells and/or fuel cells.

## Revendications

1. Raccord de cellule (1) de forme plate pour la mise en contact électrique d'au moins deux sources de courant plates (2, 2'), constitué d'au moins une première couche électro-conductrice (3), qui comprend au moins une zone de contact (7) pour la mise en contact partielle avec chacune des sources de courant (2, 2'), **caractérisé en ce que**
a) le raccord de cellule comprend, le long de la direction principale du courant (6), au moins deux zones de contact (7), la section transversale (B1) du raccord de cellule (1) étant, dans l'au moins une zone de contact (7), dans la direction principale du courant (6), inférieure à la section transversale maximale (A) du raccord de cellule (1) dans la direction principale du courant (6), le raccord de cellule (1) comprenant une section transversale croissante et/ou décroissante dans la direction principale du courant (6),
et/ou
b) au moins la première couche électro-conductrice (3) comprend, à l'extérieur de l'au moins une zone de contact (7), au moins une zone (11), dont l'extension dans la direction principale du courant (6) n'est pas linéaire et qui est divisée par au moins deux séparations ou évidements (12) oblongs, en au moins trois bandes, qui s'étendent globalement parallèlement à la direction principale du courant (6), les évidements (12) étant conçus sous la forme de canaux, sous la forme de coudes, sous la forme d'ondulations, au moins approximativement avec une forme sinusoïdal, en forme de S et/ou de forme lamellaire.

2. Raccord de cellule (1) selon la revendication 1, **caractérisé en ce qu'**au moins la première couche (3) comprend au moins un évidement (9) pour la texturisation, qui est adjacent à l'au moins une zone de contact (7).

3. Raccord de cellule (1) selon l'une des deux revendications précédentes, **caractérisé en ce que** le nombre d'évidements (9) correspond au nombre de zones de contact (7).

4. Raccord de cellule (1) selon l'une des revendications 2 à 3, **caractérisé en ce qu'**au moins deux évidements (9) sont adjacents à chaque zone de contact (7).

5. Raccord de cellule (1) selon la revendication précédente, **caractérisé en ce que** deux évidements (9) sont adjacents à chaque zone de contact (7), qui sont disposés chacun sur un côté opposé de la zone de contact (7).

6. Raccord de cellule (1) selon l'une des revendications précédentes, **caractérisé en ce que**, sur le côté opposé à la source de courant de la première couche (3), se trouve une deuxième couche conductrice de courant (4) qui est mise partiellement en contact avec la première couche (3) par l'intermédiaire d'au moins un contact (5).

7. Raccord de cellule (1) selon la revendication précédente, **caractérisé en ce que**, sur la deuxième couche (4), se trouve au moins une autre couche conductrice de courant, qui est mise partiellement en contact avec la couche située respectivement en dessous par l'intermédiaire d'au moins un contact.

8. Raccord de cellule (1) selon l'une des revendications précédentes, **caractérisé en ce qu'**au moins la première couche électro-conductrice (3) comprend, à l'extérieur de l'au moins une zone de contact (7), au moins deux zones (11) et (11'), qui comprennent au moins deux évidements (12) de forme oblongue pour la texturisation, dont l'extension dans la direction principale du courant (6) n'est pas linéaire, les zones (11) et (11') étant reliées par l'intermédiaire d'une zone (13) qui ne présente aucun évidement.

9. Raccord de cellule (1) selon l'une des revendications précédentes, **caractérisé en ce que**, pour chaque source de courant (2, 2'), au moins 2, de préférence de 3 à 10 zones de contact (7) sont prévues.

10. Raccord de cellule (1) selon l'une des revendications précédentes, **caractérisé en ce que** l'au moins une zone de contact (7) prévue par source de courant (2, 2') se trouve globalement au bord du raccord de cellule (1).

11. Raccord de cellule (1) selon l'une des revendications 1 à 5, **caractérisé en ce que** l'au moins une zone de contact (7) et/ou (5), prévue par source de courant (2, 2'), est disposée transversalement par rapport à la direction du courant (6) globalement au centre du raccord de cellule (1).

12. Raccord de cellule (1) selon l'une des revendications précédentes, **caractérisé en ce que**, entre la première couche (3) et les sources de courant (2, 2') et/ou entre la première (3) et la deuxième couche (4) et/ou entre les couches supplémentaires, se trouve une couche isolante, la couche isolante étant traversée par les zones de contact (7).

13. Raccord de cellule (1) selon l'une des revendications précédentes, **caractérisé en ce que** les épaisseurs de l'au moins une première (3) et/ou de chaque couche supplémentaire sont, indépendamment les unes des autres, entre 10 µm et 300 µm, de préférence entre 20 µm et 100 µm.

14. Raccord de cellule (1) selon l'une des revendications précédentes, pour le raccordement électrique d'au moins deux sources de courant plates (2, 2'), de préférence des cellules photovoltaïque et/ou des cellules à combustible.
